# EUROPEAN PATENT APPLICATION

(11) **EP 4 852 330 A1**
(43) Date of publication of application: **09.12.2026**
(21) Application number: 24922388.4
(22) Date of filing: 30.01.2024
(51) Int. Cl.: H03M 13/13

(54) **COMMUNICATION DEVICE AND COMMUNICATION METHOD**

(71) Applicant: NTT DOCOMO, INC., Tokyo 100-6150 (JP)
(72) Inventor: OBARA, Tatsunori, Tokyo 100-6150 (JP); SHIBAIKE, Naoya, Tokyo 100-6150 (JP); WATANABE, Ryouyuu, Tokyo 100-6150 (JP); MARUMO, Ryo, Tokyo 100-6150 (JP); NAGATA, Satoshi, Tokyo 100-6150 (JP); MIKI, Nobuhiko, Takamatsu-shi, Kagawa 761-0396 (JP)
(74) Representative: Hoffmann Eitle
(86) International application number: PCT/JP2024/002892
(87) International publication number: WO 2025/163755

(57) **Abstract**

A communication device includes: a control unit configured to generate a codeword obtained by encoding information bits by using enhanced Polar codes to which addition of XOR (Exclusive OR) operation and stopping of polarization by deletion of XOR operation are applied; and a transmission unit configured to transmit the codeword to another communication device.

## Description

### TECHNICAL FIELD

The present invention relates to a communication device and a communication method in a wireless communication system.

### BACKGROUND ART

In 3GPP (registered trademark) (3rd Generation Partnership Project), in order to realize even larger system capacity, even faster data transmission speeds, even lower latency in a wireless communication section, etc., a wireless communication method called "5G" or "NR (New Radio)" is being discussed (hereinafter, the wireless communication method is referred to as "5G" or "NR"). In 5G, various wireless technologies have been discussed in order to meet requirements including latency equal to or less than 1 ms in a wireless section while realizing a throughput equal to or greater than 10 Gbps.

In NR, an architecture is being discussed which includes: 5GC (5G Core Network) corresponding to EPC (Evolved Packet Core) that is a core network in an LTE (Long Term Evolution) network architecture; and NG-RAN (Next Generation - Radio Access Network) corresponding to E-UTRAN (Evolved Universal Terrestrial Radio Access Network) that is a RAN (Radio Access Network) in the LTE network architecture (for example, Non-Patent Literature 1 and Non-Patent Literature 2).

In addition, requirements for ultra-high-speed, high-capacity communication, ultra-coverage extension, ultra-low power consumption, low cost, ultra-low delay, ultra-high reliability indication, and ultra-multi-connection/sensing are listed in order to implement 6G. In addition, Polar coding is one of the candidates for error correction codes, which is one of the important elemental technologies being discussed in order to satisfy the above-described requirements.

### CITATION LIST

### Non-Patent Literature

Non-Patent Literature 1: 3GPP TS 23.501 V17.11.0 (2023-12)
Non-Patent Literature 2: 3GPP TS 38.401 V17.7.0 (2024-01)
Non-Patent Literature 3: E. Arikan, "A Short Course on Polar Coding Theory and Applications"
Non-Patent Literature 4: 3GPP TS 38.212 V17.7.0 (2024-01)

### SUMMARY OF INVENTION

### TECHNICAL PROBLEM

In NR, Polar coding is adopted (refer to Non-Patent Literature 3 and Non-Patent Literature 4). For polar coding, which is one of the candidates for error correction codes and is being discussed in order to implement 6G, improving performance has been difficult, particularly in a case where the codeword length is short.

In view of the above-described points, the present invention has been made to improve performance of Polar coding in the wireless communication system.

### SOLUTION TO PROBLEM

According to the disclosed technique, a device is provided. The device includes: a control unit configured to generate a codeword obtained by encoding information bits by using enhanced Polar codes to which addition of XOR (Exclusive OR) operation and stopping of polarization by deletion of XOR operation are applied; and a transmission unit configured to transmit the codeword to another communication device.

### ADVANTAGEOUS EFFECTS OF INVENTION

According to the disclosed technique, performance of Polar coding can be improved in the wireless communication system.

### BRIEF DESCRIPTION OF DRAWINGS

[Fig. 1] is a drawing for describing an example of a communication system.
[Fig. 2] is a drawing for describing an example of communication channel polarization.
[Fig. 3] is a drawing for describing Polar coding.
[Fig. 4] is a first drawing for describing convolutional Polar coding.
[Fig. 5] is a second drawing for describing convolutional Polar coding.
[Fig. 6] is a first drawing for describing Relaxed Polar coding.
[Fig. 7] is a second drawing for describing Relaxed Polar coding.
[Fig. 8] is a drawing illustrating an example of a functional structure of a base station 10 in an embodiment of the present invention.
[Fig. 9] is a drawing illustrating an example of a functional configuration of a terminal 20 in an embodiment of the present invention.
[Fig. 10] is a drawing illustrating an example of a hardware structure of the base station 10 or the terminal 20 according to an embodiment of the present invention.
[Fig. 11] is a drawing illustrating an example of a structure of a vehicle 2001 in an embodiment of the present invention.

### DESCRIPTION OF EMBODIMENTS

In the following, while referring to the drawings, one or more embodiments of the present invention will be described. It should be noted that the embodiments described below are examples. Embodiments of the present invention are not limited to the following embodiments.

In operations of a wireless communication system according to an embodiment of the present invention, a conventional technique will be used when it is appropriate. It should be noted that, although the conventional techniques may be the conventional LTE, the conventional techniques are not limited to the conventional LTE. Further, it is assumed that the term "LTE" used in the present specification has, unless otherwise specifically mentioned, a broad meaning including a scheme of LTE-Advanced and a scheme after LTE-Advanced (e.g., NR).

Furthermore, in one or more embodiments described below, terms that are used in the existing LTE are used, such as SS (Synchronization signal), PSS (Primary SS), SSS (Secondary SS), PBCH (Physical broadcast channel), PRACH (Physical random access channel), PDCCH (Physical Downlink Control Channel), PDSCH (Physical Downlink Shared Channel), PUCCH (Physical Uplink Control Channel), PUSCH (Physical Uplink Shared Channel), etc. The above-described terms are used for the sake of description convenience. Signals, functions, etc., which are similar to the above-described terms, may be referred to as different names. In addition, the above-described terms in NR correspond to NR-SS, NR-PSS, NR-SSS, NR-PBCH, NR-PRACH, etc. However, even when a signal is used for NR, the signal is not required to be referred to as "NR-".

In addition, in an embodiment of the present invention, the duplex method may be a TDD (Time Division Duplex) method, an FDD (Frequency Division Duplex) method, or any other method (e.g., Flexible Duplex, or the like).

Further, in an embodiment of the present invention, the expression that a radio parameter, or the like is "configured" may mean that a predetermined value is pre-configured, or may mean that a radio parameter indicated by a base station 10 or a terminal 20 is configured.

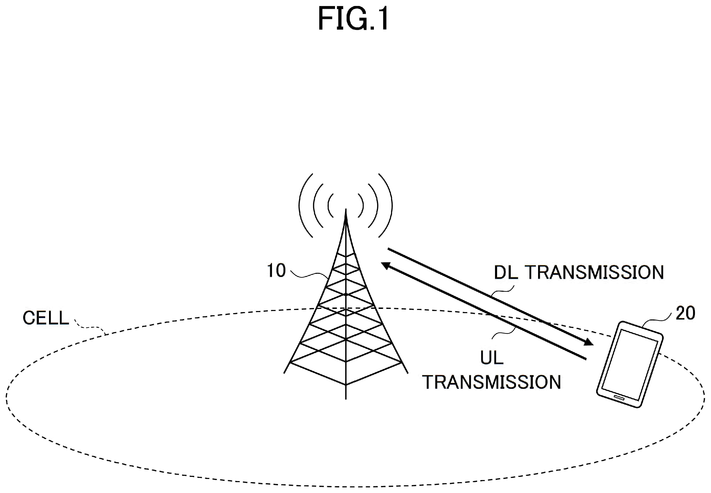

Fig. 1 is a drawing illustrating a configuration example of a wireless communication system according to an embodiment of the present invention. As illustrated in Fig. 1, a wireless communication system according to an embodiment of the present invention includes a base station 10 and a terminal 20. In Fig. 1, a single base station 10 and a single terminal 20 are illustrated as an example, but there may be a plurality of base stations 10 and a plurality of terminals 20.

The base station 10 is a communication device that provides one or more cells and performs wireless communication with the terminal 20. Physical resources of radio signals may be defined in the time domain and the frequency domain, the time domain may be defined by the number of OFDM (Orthogonal Frequency Division Multiplexing) symbols, and the frequency domain may be defined by the number of sub-carriers or resource blocks. The base station 10 transmits a synchronization signal and system information to the terminal 20. The synchronization signal is, for example, an NR-PSS and/or an NR-SSS. The system information may be transmitted via an NR-PBCH, and may be referred to as broadcast information. The synchronization signal and the system information may be referred to as an SSB (SS/PBCH block). As shown in Fig. 1, the base station 10 transmits a control signal or data in DL (Downlink) to the terminal 20 and receives a control signal or data in UL (Uplink) from the terminal 20. The base station 10 and terminal 20 are capable of transmitting and receiving a signal by performing the beamforming. Further, the base station 10 and the terminal 20 can both apply MIMO (Multiple Input Multiple Output) communication to DL or UL. Further, the base station 10 and the terminal 20 may both perform communications via a secondary cell (SCell: Secondary Cell) and a primary cell (PCell: Primary Cell) using CA (Carrier Aggregation). In addition, the terminal 20 may perform communications via a primary cell of the base station 10 and a primary secondary cell group cell (PSCell: Primary SCG Cell) of another base station 10 using DC (Dual Connectivity).

The terminal 20 may be a communication apparatus that includes a wireless communication function such as a smartphone, a mobile phone, a tablet, a wearable terminal, a communication module for M2M (Machine-to-Machine), or the like. As shown in Fig. 1, the terminal 20 uses various communication services provided by the wireless communication system by receiving control signals or data in DL from the base station 10 and transmitting control signals or data in UL to the base station 10. In addition, the terminal 20 receives various reference signals transmitted from the base station 10 and performs measurement of the propagation path quality based on the reception result of the reference signals.

In addition, various requirements for the next generation "6G" are being discussed. For example, the requirements may include ultra broadband communication, mission critical communication, ultra massive connection, universal coverage, intelligent connection, ubiquitous sensing, and the like.

In addition, the requirements may include ultra high speed communication, large capacity communication, ultra coverage enhancement, ultra low energy consumption, low cost, ultra low latency, ultra high reliability communication, massive connectivity and sensing, and the like.

In order to satisfy the above-described requirements, as a new concept, the goals are set to be extensible (for example, capable of being effectively used in the future), easy-operational, customizable (for example, capable of being easily operational), and sustainable (for example, capable of reducing cost, capable of having a robust structure, capable of having resilience). In addition, as a guaranteed communication, always guaranteeing the minimum performance is being discussed.

In addition, requirements for ultra-high-speed, high-capacity communication, ultra-coverage extension, ultra-low power consumption, low cost, ultra-low delay, ultra-high reliability indication, and ultra-multi-connection/sensing are listed in order to implement 6G. In addition, Polar coding (also referred to as Polar codes) is one of the candidates for error correction codes, which is one of the important elemental technologies being discussed in order to satisfy the above-described requirements.

Polar coding is coding that can achieve error characteristics that asymptotically approach the Shannon limit by using communication channel polarization, which is adopted as control channel error correction codes for 5G NR. In addition, Polar coding is also being discussed to be a promising candidate for error correction coding for 6G.

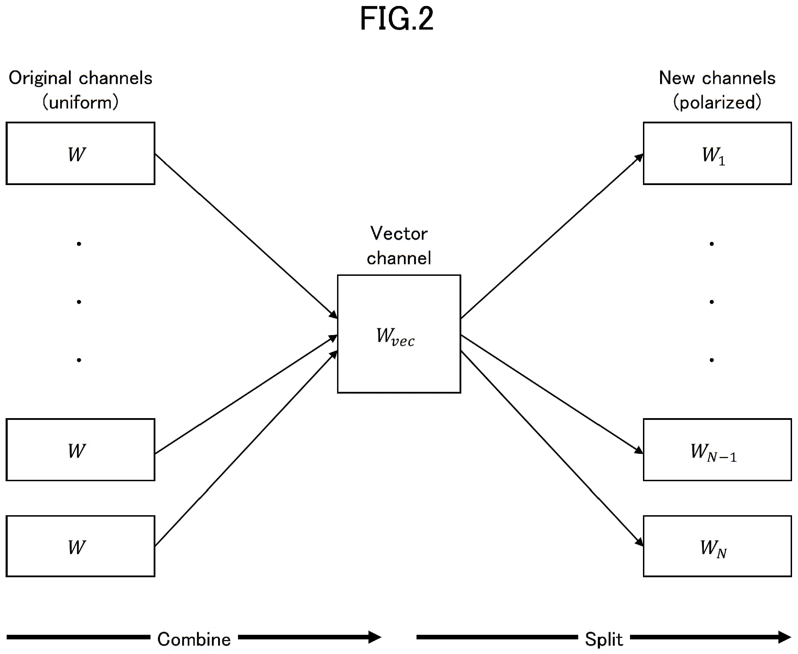

Fig. 2 is a drawing for describing an example of communication channel polarization. As illustrated in Fig. 2, in the channel polarization, uniform original channels are converted to polarized new channels by having the uniform original channels combined and split.

In addition, there are two types of coding as variations of Polar coding that are the convolutional Polar coding and the relaxed Polar coding. The convolutional Polar coding is a method in which the communication channel polarization is accelerated without changing the codeword length by introducing the convolutional configuration (addition of XOR operation). On the other hand, the relaxed Polar coding is a method in which a more than required communication channel polarization is stopped (XOR operation is deleted), and thus, unnecessary generation of poor communication channel is eliminated while reducing the operation amount.

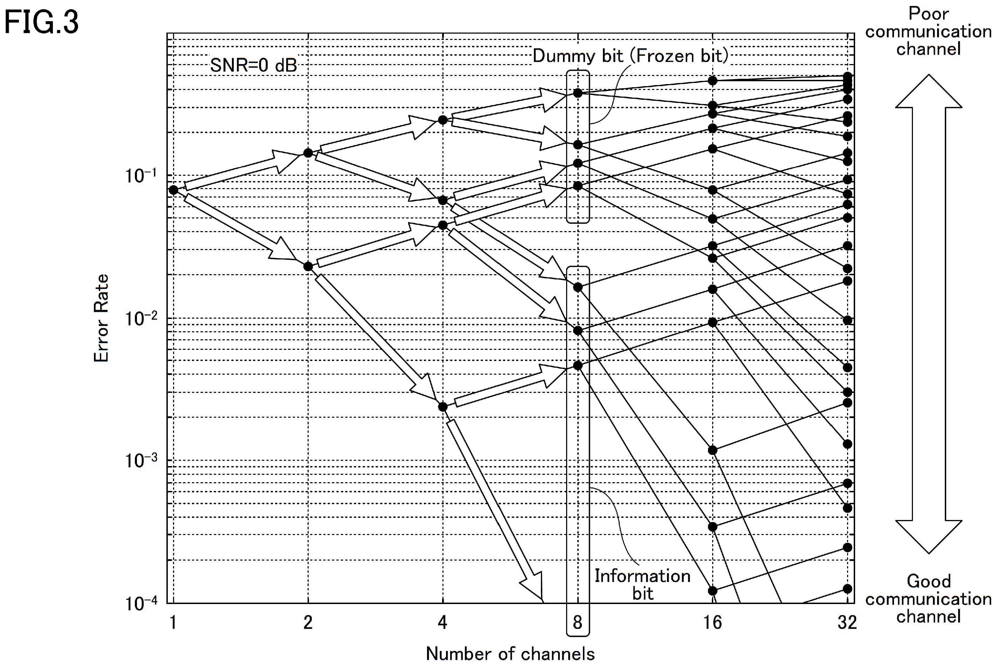

Fig. 3 is a drawing for describing Polar coding. As illustrated in Fig. 3, in the communication channel polarization using XOR operation in the Polar coding, the error rate performance with respect to information bits can be improved by increasing the polarization into poor communication channels and good communication channels as the codeword length increases. However, in a case where the codeword length is short, the polarization is decreased and the performance improvement is limited.

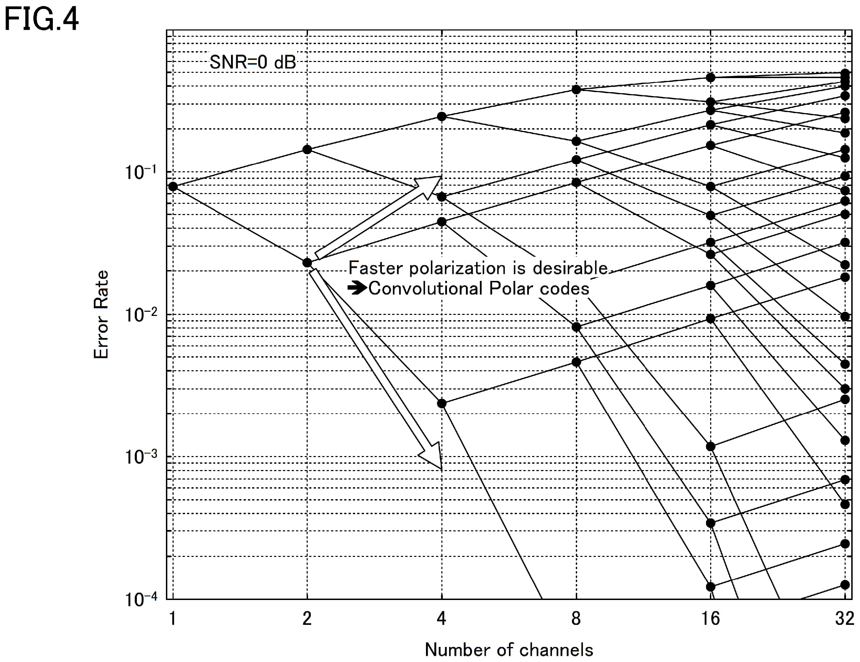

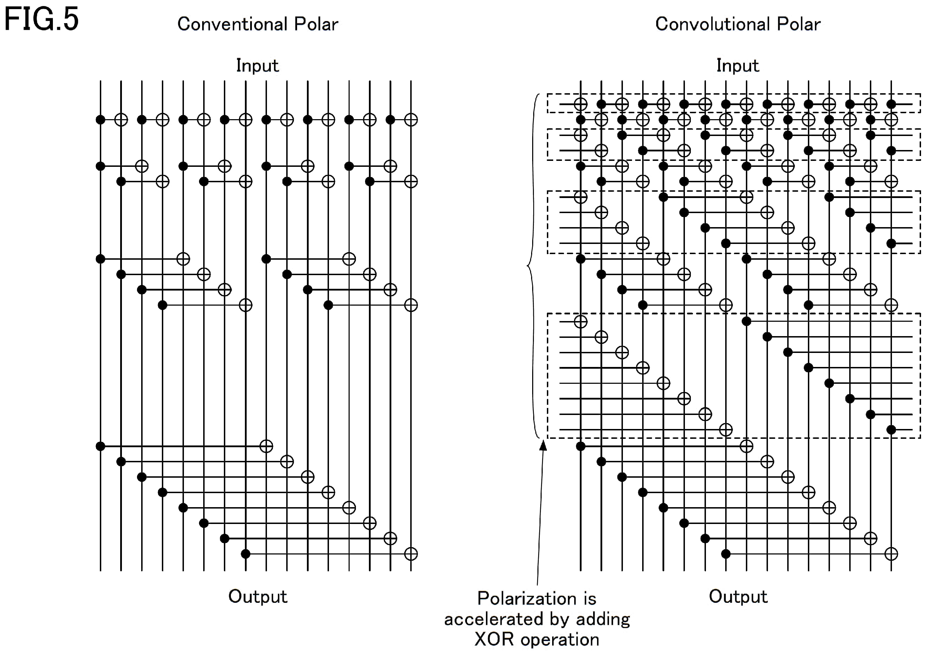

Fig. 4 and Fig. 5 are respectively first and second drawings for describing the convolutional Polar coding. As illustrated in Fig. 4 and Fig. 5, in the convolutional Polar coding, the polarization can be accelerated by adding XOR operation to the encoder as compared with the conventional Polar coding.

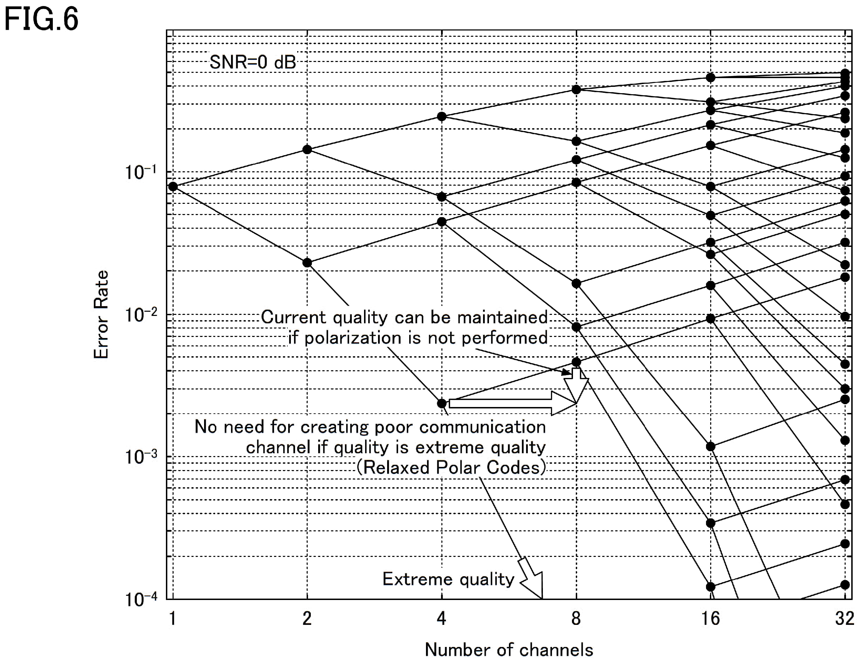

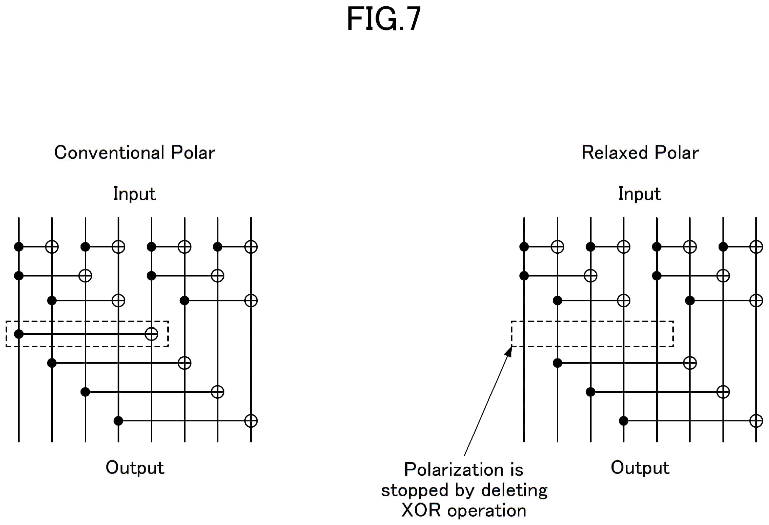

Fig. 6 and Fig. 7 are respectively first and second drawings for describing the convolutional Polar coding. As illustrated in Fig. 6 and Fig. 7, in the relaxed Polar coding, the polarization is stopped by deleting the XOR operation from the encoder when a certain level of quality is satisfied by communication channels. In other words, there is no need for generating poor communication channels if the quality is excessive quality, and thus, quality in which the current quality is maintained is obtained by not performing polarization.

### (Embodiment)

Embodiment(s) will be described. In an embodiment of the present invention, a method of improving the performance for the short codeword length by combining the convolutional Polar coding and the relaxed Polar coding will be described. In addition, in an embodiment of the present invention, a method related to the enhanced Polar coding (enhanced Polar codes) that has a function of accelerating the communication channel polarization by adding XOR operation and a function of stopping the communication channel polarization by deleting XOR operation in the wireless communication system will be described. In addition, for example, the method of Polar coding, the encoder, and the configuration related to coding will be also applied to the method of decoding the codeword, the decoder, and the configuration related to decoding in a similar manner.

### (First embodiment)

In the first embodiment, in the Polar coding, a method of code generation in which the communication channel polarization is accelerated by adding XOR operation and the polarization is stopped by deleting XOR operation for a communication channel that has satisfied a certain level of quality will be described.

According to the method in the first embodiment, even in a case where the codeword length is short, the performance of Polar coding can be improved by preventing the generation of unnecessary poor communication channels by stopping the polarization of a communication channel that has reached a certain level of quality in conjunction with accelerating the communication channel polarization by adding XOR operation.

### (First method)

The base station 10 and the terminal 20 may determine the addition position of XOR operation in the encoder for accelerating the communication channel polarization in the Polar coding, based on at least one of the following methods.

### (Method 1-1)

The base station 10 and the terminal 20 may use an XOR operation addition rule that is specified in advance in the technical specifications, or the like. For example, the XOR operation addition rule may be specified in the form of code generation matrix, or an operation process for each of the codeword bits may be specified.

### (Method 1-2)

The base station 10 and the terminal 20 may use an XOR operation addition pattern that is specified in advance in the technical specifications, or the like. For example, a configuration diagram of an encoder of Polar coding in which XOR operation is added may be explicitly specified as an XOR operation addition pattern.

### (Second method)

The base station 10 and the terminal 20 may determine the communication channel quality for determining the stopping of communication channel polarization (deleting of XOR operation) in the relax Polar coding, based on at least one of the following methods.

### (Method 2-1)

The base station 10 and the terminal 20 may determine the communication channel quality for stopping of communication channel polarization in Polar coding to be a case in which the communication channel capacity of a good communication channel is equal to or greater than a defined threshold value. In other words, the base station 10 and the terminal 20 may stop the communication channel polarization in Polar coding in a case where the communication channel capacity of a good communication channel is equal to or greater than a defined threshold value.

### (Method 2-2)

The base station 10 and the terminal 20 may determine the communication channel quality for stopping of communication channel polarization in Polar coding to be a case in which the error rate of a good communication channel is equal to or less than a defined threshold value. In other words, the base station 10 and the terminal 20 may stop the communication channel polarization in Polar coding in a case where the error rate of a good communication channel is equal to or greater than a defined threshold value.

### (Method 2-3)

The base station 10 and the terminal 20 may determine the communication channel quality for stopping of communication channel polarization in Polar coding to be a case in which the communication channel capacity of a poor communication channel is equal to or less than a defined threshold value. In other words, the base station 10 and the terminal 20 may stop the communication channel polarization in Polar coding in a case where the communication channel capacity of a poor communication channel is equal to or less than a defined threshold value.

### (Method 2-4)

The base station 10 and the terminal 20 may determine the communication channel quality for stopping of communication channel polarization in Polar coding to be a case in which the error rate of a poor communication channel is equal to or greater than a defined threshold value. In other words, the base station 10 and the terminal 20 may stop the communication channel polarization in Polar coding in a case where the error rate of a poor communication channel is equal to or greater than a defined threshold value.

In addition, in the above-described method 2-1 to the above-described method 2-4, the communication channel capacity and the error rate may be calculated from theoretical values, or may be calculated in advance according to a value calculation using a simulator, or the like. In addition, the threshold value may be determined based on the desired quality, may be changed in accordance with the coding rate, or may be changed in accordance with the modulation method. In addition, the threshold value may be pre-defined in the technical specification, or may be configured by the base station 10 and the terminal 20.

### (Third method)

The base station 10 and the terminal 20 may determine the deletion position of XOR operation in the encoder for stopping the communication channel polarization in the Polar coding (XOR operation deletion), based on at least one of the following methods.

### (Method 3-1)

The base station 10 and the terminal 20 may use an XOR operation deletion rule according to the threshold value determination in the second method, that is specified in advance in the technical specifications, or the like. For example, the XOR operation deletion rule may be specified in the form of a code generation matrix, or an operation process for each of the codeword bits may be specified.

### (Method 3-2)

The base station 10 and the terminal 20 may use an XOR operation deletion pattern according to the threshold value determination in the second method, that is specified in advance in the technical specifications, or the like. For example, a configuration diagram of an encoder of Polar coding in which XOR operation is deleted may be explicitly specified as an XOR operation deletion pattern.

### (Fourth method)

The base station 10 and the terminal 20 may use both of or only one of: the XOR operation addition for accelerating the communication channel polarization; and the XOR operation deletion for stopping the communication channel polarization in the Polar coding.

### (Fifth method)

The base station 10 and the terminal 20 may limit the signal, channel, and coding information to which the method related to Polar coding in an embodiment of the present invention is applied.

For example, the signal, channel, and coding information may be limited to: only uplink channel control information (UCI, Uplink Control Information) including feedback information (HARQ-ACK, Hybrid Automatic Repeat request-Acknowledgement); only UCI including channel state information (CSI); only a downlink control channel (PDCCH); PDCCH including a defined size (for example, equal to or greater than X bits) of payload; or only a downlink data channel (PDSCH) and/or an uplink data channel (PUSCH), for example.

In addition, the base station 10 and the terminal 20 may support both the Polar coding specified in 5G NR Rel-15 and the enhanced Polar coding based on the method in an embodiment of the present invention, or may support only the enhanced Polar coding based on the method in an embodiment of the present invention.

### (Second embodiment)

In the second embodiment, configuration information related to the enhanced Polar coding described in the first embodiment and an indication method of the configuration information will be described.

According to the method described in the second embodiment, the same configuration information related to the enhanced Polar coding described in the first embodiment will be able to be used between a plurality of communication devices (for example, from the base station 10 to the terminal 20, from the terminal 20 to the base station 10, between a plurality of terminals 20).

### (First method)

The configuration information related to the Polar coding may be indicated between the communication devices according to the following methods.

### (Method 1-1)

The base station 10 and the terminal 20 may indicate the configuration information related to the Polar coding by using the RRC (Radio Resource Control) protocol.

### (Method 1-2)

The base station 10 and the terminal 20 may indicate the configuration information related to the Polar coding by using MAC (Medium Access Control) CE (Control Element).

### (Method 1-3)

The base station 10 and the terminal 20 may indicate the configuration information related to the Polar coding by using DCI (Downlink Control Information) or UCI (Uplink Control Information).

### (Second method)

The base station 10 and the terminal 20 may indicate the configuration information related to the Polar coding as described below. Here, the configuration information may be referred to as a parameter.

### (Method 2-1)

The base station 10 and the terminal 20 may indicate information related to the codeword length as the configuration information related to the Polar coding.

### (Method 2-2)

The base station 10 and the terminal 20 may indicate information related to the XOR operation addition position as the configuration information related to the Polar coding.

### (Method 2-3)

The base station 10 and the terminal 20 may indicate an index indicating the XOR operation addition pattern as the configuration information related to the Polar coding.

### (Method 2-4)

The base station 10 and the terminal 20 may indicate information related to the XOR operation deletion position as the configuration information related to the Polar coding.

### (Method 2-5)

The base station 10 and the terminal 20 may indicate an index indicating the XOR operation deletion pattern as the configuration information related to the Polar coding.

### (Method 2-6)

The base station 10 and the terminal 20 may indicate information related to the threshold value for determining XOR operation deletion as the configuration information related to the Polar coding. The threshold value is, for example, a threshold value used in the second method (method 2-1 to method 2-4) of the first embodiment.

### (Method 2-7)

The base station 10 and the terminal 20 may indicate an index indicating a threshold value pattern for determining the XOR operation deletion as the configuration information related to the Polar coding. The threshold value is, for example, a threshold value used in the second method (method 2-1 to method 2-4) of the first embodiment.

### (Method 2-8)

The base station 10 and the terminal 20 may indicate information related to an index indicating the reliability table for each of the codeword bits for determining the information bits and/or frozen bits as the configuration information related to the Polar coding. Here, the information bits and the frozen bits (also referred to as dummy bits or known bits) are respectively bits that are transmitted by good communication channels and bits that are transmitted by poor communication channels in the codeword in Polar coding. In addition, the reliability table includes a value indicating the reliability for each of the bits in the codeword in Polar coding, and a bit whose reliability is equal to or greater than a defined threshold value is treated as an information bit.

### (Third method)

In a case where configuration information related to the enhanced Polar coding described in the first embodiment is configured, and/or in a case where the configuration information is indicated, the base station 10 and the terminal 20 may expect that at least one processing period described as below is to be a period that is shorter than the processing period that is expected in the Polar coding in the conventional technical specification.

### (Method 3-1)

The base station 10 and the terminal 20 may expect that the decoding period of the downlink control channel (PDCCH) and/or the downlink control information (DCI) is to be a shorter period. Here, the decoding period of PDCCH and/or DCI may be replaced with a default beam assumed period.

### (Method 3-2)

The base station 10 and the terminal 20 may expect that the decoding period of the downlink data channel (PDSCH) is to be a shorter period. Here, the decoding period of PDSCH may be denoted as N1.

### (Method 3-3)

The base station 10 and the terminal 20 may expect that the preparation period of the uplink data channel (PUSCH) is to be a shorter period. Here, the preparation period of PUSCH may be denoted as N2.

### (Method 3-4)

The base station 10 and the terminal 20 may expect that the preparation period of the feedback information (HARQ-ACK) is to be a shorter period.

### (Method 3-5)

The base station 10 and the terminal 20 may expect that the preparation period of the uplink control channel (PUCCH) is to be a shorter period.

### (Method 3-6)

The base station 10 and the terminal 20 may expect that the decoding period of the uplink data channel (PUSCH) is to be a shorter period.

### (Third embodiment)

In the third embodiment, in a case where the enhanced Polar coding described in the first embodiment is used, the base station 10 and the terminal 20 may have a plurality of coding configurations with different XOR addition positions and/or deletion positions if required quality is different based on a specific condition. For example, having a plurality of coding configurations may mean using a plurality of configuration information sets related to Polar coding.

According to the above-described operation, the performance of Polar coding can be improved by using a most appropriate coding configuration of Polar coding depending on the condition.

### (First method)

The base station 10 and the terminal 20 may have different coding configurations of Polar coding in accordance with the following conditions.

### (Method 1-1)

The base station 10 and the terminal 20 may have different coding configurations in accordance with the type of coding information (for example, control channel, data channel, or the like).

### (Method 1-2)

The base station 10 and the terminal 20 may have different coding configurations in accordance with the priority of the coding information.

### (Method 1-3)

The base station 10 and the terminal 20 may have different coding configurations in accordance with the states of the base station 10 and the terminal 20 themselves (for example, the state of the communication channel).

### (Second method)

The base station 10 and the terminal 20 may indicate different configuration information related to the Polar coding in accordance with the specific condition(s) described in the first method by using at least one of the following methods.

### (Method 2-1)

The base station 10 and the terminal 20 may indicate different configuration information in accordance with the specific condition by using the RRC (Radio Resource Control) protocol.

### (Method 2-2)

The base station 10 and the terminal 20 may indicate different configuration information in accordance with the specific condition by using MAC (Medium Access Control) CE (Control Element).

### (Method 2-3)

The base station 10 and the terminal 20 may indicate different configuration information in accordance with the specific condition by using DCI (Downlink Control Information) or UCI (Uplink Control Information).

### (Third method)

The base station 10 and the terminal 20 may include configuration information related to the Polar coding described below in the configuration information described in the second method.

### (Method 3-1)

The base station 10 and the terminal 20 may include information related to the codeword length in the configuration information described in the second method.

### (Method 3-2)

The base station 10 and the terminal 20 may include information related to the XOR operation addition position in the configuration information described in the second method.

### (Method 3-3)

The base station 10 and the terminal 20 may include information related to an index indicating the XOR operation addition pattern in the configuration information described in the second method.

### (Method 3-4)

The base station 10 and the terminal 20 may include information related to the XOR operation deletion position in the configuration information described in the second method.

### (Method 3-5)

The base station 10 and the terminal 20 may include information related to an index indicating the XOR operation deletion pattern in the configuration information described in the second method.

### (Method 3-6)

The base station 10 and the terminal 20 may include information related to the threshold value for determining the XOR operation deletion in the configuration information described in the second method. The threshold value is, for example, a threshold value used in the second method (method 2-1 to method 2-4) of the first embodiment.

### (Method 3-7)

The base station 10 and the terminal 20 may include information related to an index indicating the threshold value pattern for determining XOR operation deletion as the configuration information related to the Polar coding. The threshold value is, for example, a threshold value used in the second method (method 2-1 to method 2-4) of the first embodiment.

### (Method 3-8)

The base station 10 and the terminal 20 may include information related to an index indicating the reliability table for each of the codeword bits for determining the information bit positions and/or frozen bit positions as the configuration information related to the Polar coding. Here, the information bits and the frozen bits (dummy bits) are respectively bits that are transmitted by good communication channels and bits that are transmitted by poor communication channels in the codeword in Polar coding. In addition, the reliability table includes a value indicating the reliability for each of the bits in the codeword in Polar coding, and a bit whose reliability is equal to or greater than a defined threshold value is treated as an information bit.

It is to be noted that, in an embodiment of the present invention, the frozen bit may be replaced with a known bit (for example, the known bit is 0 or 1) that is added when encoding an information bit based on Polar coding.

In addition, processes based on a part of or all of the embodiments may be performed only in a case where a specific RRC parameter is configured. Here, the "specific RRC parameter" may indicate activation/deactivation (On/Off) of the enhanced Polar coding function.

In addition, the enhanced Polar coding described in an embodiment of the present invention may be defined as an essential function (for example, Mandatory w/o UE capability signaling) in 6G (for example, technical specifications related to a RAT that is different from 5G NR and will be deployed in Rel-20 or after Rel-20), or may be defined as an optional function (Optional with UE capability signaling) in 5G NR and/or 6G. Here, the UE capability signaling used for reporting information related to the support of enhanced Polar coding described in an embodiment of the present invention from the terminal 20 to the base station 10 may be defined.

According to the above-described embodiments, performance of Polar coding can be improved in the wireless communication system.

### (Device configuration)

Next, a functional configuration example of the base station 10 and the terminal 20 for performing the processes and operations described above will be described. The base station 10 and the terminal 20 include functions for implementing the embodiments described above. It should be noted, however, that each of the base stations 10 and the terminal 20 may include only some of the functions in an embodiment.

### <Base station 10>

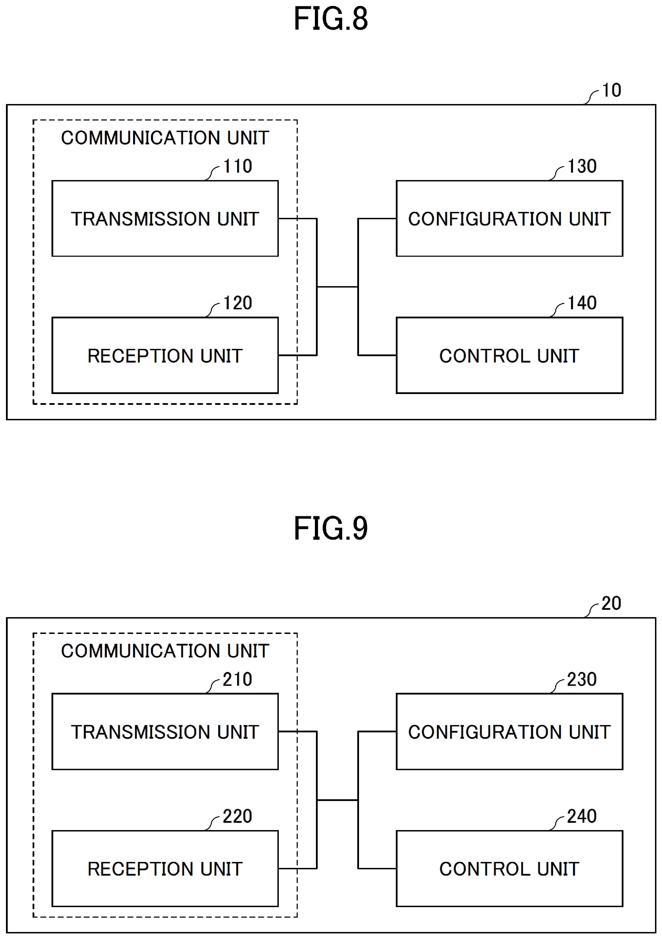

Fig. 8 is a drawing illustrating an example of a functional structure of a base station 10 according to an embodiment of the present invention. As shown in Fig. 8, the base station 10 includes a transmission unit 110, a reception unit 120, a configuration unit 130, and a control unit 140. The functional configuration illustrated in Fig. 8 is merely an example. Functional divisions and names of functional units may be anything as long as operations according to an embodiment of the present invention can be performed.

The transmission unit 110 includes a function for generating a signal to be transmitted to the terminal 20 side and transmitting the signal wirelessly. Further, the transmission unit 110 transmits an inter-network-node message to another network node. The reception unit 120 includes a function for receiving various signals transmitted from the terminal 20 and acquiring, for example, information of a higher layer from the received signals. In addition, the transmission unit 110 has a function of transmitting NR-PSS, NR-SSS, NR-PBCH, DL/UL control signals, and the like to the terminal 20. Further, the reception unit 120 receives an inter-network-node message from another network node.

The configuration unit 130 stores preset information and various configuration information items to be transmitted to the terminal 20. Contents of the configuration information are, for example, information related to the configuration of the Polar coding.

The control unit 140 performs control related to the Polar coding as described in the embodiments. In addition, the control unit 140 performs scheduling. The functional units related to signal transmission in the control unit 140 may be included in the transmission unit 110, and the functional units related to signal reception in the control unit 140 may be included in the reception unit 120.

### <Terminal 20>

Fig. 9 is a drawing illustrating an example of a functional structure of a terminal 20 according to an embodiment of the present invention. As shown in Fig. 9, the terminal 20 includes a transmission unit 210, a reception unit 220, a configuration unit 230, and a control unit 240. The functional configuration illustrated in Fig. 9 is merely an example. Functional divisions and names of functional units may be anything as long as operations according to an embodiment of the present invention can be performed.

The transmission unit 210 generates a transmission signal from transmission data and transmits the transmission signal wirelessly. The reception unit 220 receives various signals wirelessly and obtains higher layer signals from the received physical layer signals. In addition, the reception unit 220 has a function of receiving NR-PSS, NR-SSS, NR-PBCH, DL/UL/SL control signals, and the like, transmitted from the base station 10. In addition, for example, with respect to the D2D communications, the transmission unit 210 transmits, to another terminal 20, PSCCH (Physical Sidelink Control Channel), PSSCH (Physical Sidelink Shared Channel), PSDCH (Physical Sidelink Discovery Channel), PSBCH (Physical Sidelink Broadcast Channel), etc., and the reception unit 220 receives, from the another terminal 20, PSCCH, PSSCH, PSDCH, PSBCH, etc.

The configuration unit 230 stores various configuration information items received by the reception unit 220 from the base station 10. In addition, the configuration unit 230 also stores pre-configured configuration information. Contents of the configuration information are, for example, information related to the configuration of the Polar coding.

The control unit 240 performs control related to the Polar coding as described in the embodiments. The functional units related to signal transmission in the control unit 240 may be included in the transmission unit 210, and the functional units related to signal reception in the control unit 240 may be included in the reception unit 220.

### (Hardware structure)

The block diagrams that have been used to describe the above embodiments (Fig. 8 and Fig. 9) show blocks in functional units. These functional blocks (components) may be implemented in arbitrary combinations of at least one of hardware or software. Also, the method for implementing each functional block is not particularly limited. That is, each functional block may be realized by one piece of apparatus that is physically or logically coupled, or may be realized by directly or indirectly connecting two or more physically or logically separate pieces of apparatus (for example, via wire, wireless, or the like) and using these pieces of apparatus. The functional blocks may be implemented by combining software into the apparatus described above or the plurality of apparatuses described above.

Functions include judgment, determination, decision, calculation, computation, processing, derivation, investigation, search, confirmation, reception, transmission, output, access, resolution, selection, designation, establishment, comparison, assumption, expectation, considering, broadcasting, notifying, communicating, forwarding, configuring, reconfiguring, allocating (mapping), assigning, and the like, but function are by no means limited to these. For example, functional block (components) to implement a function of transmission may be referred to as a "transmitting section (transmitting unit)," a "transmitter," and the like. The method for implementing each component is not particularly limited as described above.

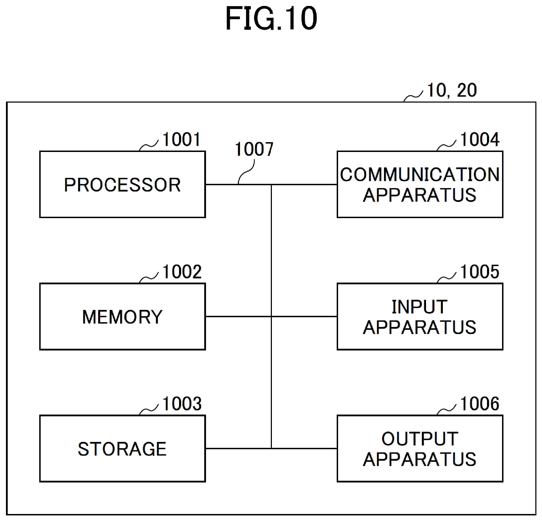

For example, the base station 10, the terminal 20, etc., according to an embodiment of the present disclosure may function as a computer for processing the radio communication method of the present disclosure. Fig. 10 is a drawing illustrating an example of a hardware structure of the base station 10 and the terminal 20 according to one embodiment. Physically, the above-described base station 10 and terminal 20 may each be formed as a computer apparatus that includes a processor 1001, a memory 1002, a storage 1003, a communication apparatus 1004, an input apparatus 1005, an output apparatus 1006, a bus 1007, and so on.

Note that in the present disclosure, the words such as an apparatus, a circuit, a device, a section, a unit, and so on can be interchangeably interpreted. The hardware structure of the base station 10 and the terminal 20 may be configured to include one or more of apparatuses shown in the drawings, or may be configured not to include part of apparatuses.

Each function of the base station 10 and the terminals 20 is implemented, for example, by allowing certain software (programs) to be read on hardware such as the processor 1001 and the memory 1002, and by allowing the processor 1001 to perform calculations to control communication via the communication apparatus 1004 and control at least one of reading or writing of data in the memory 1002 and the storage 1003.

The processor 1001 controls the whole computer by, for example, running an operating system. The processor 1001 may be configured with a central processing unit (CPU), which includes interfaces with peripheral apparatus, control apparatus, computing apparatus, a register, and so on. For example, the above-described control unit 140, control unit 240, and so on may be implemented by the processor 1001.

Furthermore, the processor 1001 reads programs (program codes), software modules, data, or the like, from at least one of the storage 1003 or the communication apparatus 1004, into the memory 1002, and executes various processes according to these. As for the programs, programs to allow computers to execute at least part of the operations of the above-described embodiments are used. For example, the control unit 140 of the base station 10 illustrated in Fig. 8 may be implemented by control programs that are stored in the memory 1002 and that operate on the processor 1001. In addition, for example, the control unit 240 of the terminal 20 illustrated in Fig. 9 may be implemented by control programs that are stored in the memory 1002 and that operate on the processor 1001. The various processes have been described to be performed by a single processor 1001. However, the processes may be performed by two or more processors 1001 simultaneously or sequentially. The processor 1001 may be implemented by one or more chips. It should be noted that the program may be transmitted from a network via a telecommunication line.

The memory 1002 is a computer-readable recording medium, and may be constituted with, for example, at least one of a Read Only Memory (ROM), an Erasable Programmable ROM (EPROM), an Electrically Erasable Programmable ROM (EEPROM), a Random Access Memory (RAM), or other appropriate storage media. The memory 1002 may be referred to as a "register," a "cache," a "main memory (primary storage apparatus)" and so on. The memory 1002 can store executable programs (program codes), software modules, and the like for implementing the communication method according to one embodiment of the present disclosure.

The storage 1003 is a computer-readable recording medium, and may be constituted with, for example, at least one of a flexible disk, a floppy (registered trademark) disk, a magneto-optical disk (for example, a compact disc (Compact Disc ROM (CD-ROM) and so on), a digital versatile disc, a Blu-ray (registered trademark) disk), a removable disk, a hard disk drive, a smart card, a flash memory device (for example, a card, a stick, and a key drive), a magnetic stripe, a database, a server, or other appropriate storage media. The above recording medium may be a database including the memory 1002 and/or the storage 1003, a server, or any other appropriate medium.

The communication apparatus 1004 is hardware (transmitting/receiving device) for allowing inter-computer communication via at least one of wired or wireless networks, and may be referred to as, for example, a "network device," a "network controller," a "network card," a "communication module," and so on. The communication apparatus 1004 may be configured to include a high frequency switch, a duplexer, a filter, a frequency synthesizer, and so on in order to realize, for example, at least one of frequency division duplex (FDD) or time division duplex (TDD). For example, the transmitting/receiving antenna, the amplifier unit, the transmitting/receiving unit, the transmission line interface, and the like, may be implemented by the communication apparatus 1004. The transmitting/receiving unit may be physically or logically divided into a transmitting unit and a receiving unit.

The input apparatus 1005 is an input device that receives input from the outside (for example, a keyboard, a mouse, a microphone, a switch, a button, a sensor, and so on). The output apparatus 1006 is an output device that outputs something to the outside (e.g., display, speaker, LED lamp). Note that the input apparatus 1005 and the output apparatus 1006 may be provided in an integrated structure (for example, a touch panel).

Furthermore, these types of apparatus, including the processor 1001, the memory 1002, and others, are connected by a bus 1007 for communicating information. The bus 1007 may be formed with a single bus, or may be formed with buses that vary between pieces of apparatus.

Also, the base station 10 and the terminals 20 may be structured to include hardware such as a microprocessor, a digital signal processor (DSP), an Application Specific Integrated Circuit (ASIC), a Programmable Logic Device (PLD), a Field Programmable Gate Array (FPGA), and so on, and part or all of the functional blocks may be implemented by the hardware. Also, the O-DU 11 and the O-RU 12 may be structured to include hardware such as a microprocessor, a digital signal processor (DSP), an Application Specific Integrated Circuit (ASIC), a Programmable Logic Device (PLD), a Field Programmable Gate Array (FPGA), and so on, and part or all of the functional blocks may be implemented by the hardware. For example, the processor 1001 may be implemented with at least one of these pieces of hardware.

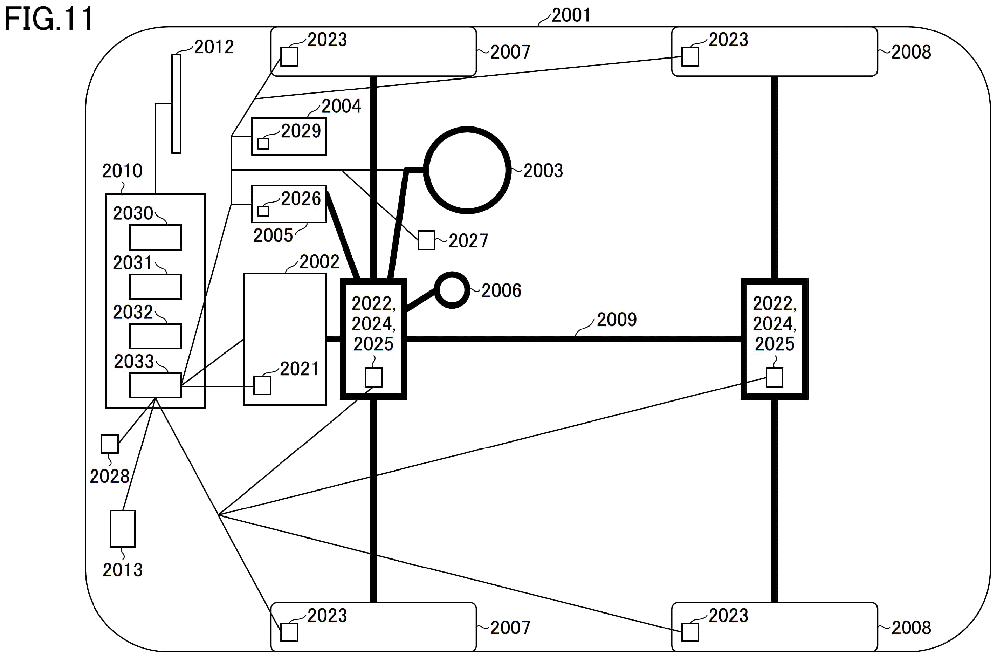

Fig. 11 shows an example of a configuration of a vehicle 2001. As shown in Fig. 11, the vehicle 2001 includes a drive unit 2002, a steering unit 2003, an accelerator pedal 2004, a brake pedal 2005, a shift lever 2006, a front wheel 2007, a rear wheel 2008, an axle 2009, an electronic control unit 2010, various sensors 2021-2029, an information service unit 2012, and a communication module 2013. The aspects/embodiments described in the present disclosure may be applied to a communication device mounted in the vehicle 2001, and may be applied to, for example, the communication module 2013.

The drive unit 2002 may include, for example, an engine, a motor, and a hybrid of an engine and a motor. The steering unit 2003 includes at least a steering wheel and is configured to steer at least one of the front wheels or the rear wheels, based on the operation of the steering wheel operated by the user.

The electronic control unit 2010 includes a microprocessor 2031, a memory (ROM, RAM) 2032, and a communication port (IO port) 2033. The electronic control unit 2010 receives signals from the various sensors 2021-2029 provided in the vehicle 2001. The electronic control unit 2010 may be referred to as an ECU (Electronic control unit).

The signals from the various sensors 2021 to 2029 include a current signal from a current sensor 2021 which senses the current of the motor, a front or rear wheel rotation signal acquired by a revolution sensor 2022, a front or rear wheel pneumatic signal acquired by a pneumatic sensor 2023, a vehicle speed signal acquired by a vehicle speed sensor 2024, an acceleration signal acquired by an acceleration sensor 2025, a stepped-on accelerator pedal signal acquired by an accelerator pedal sensor 2029, a stepped-on brake pedal signal acquired by a brake pedal sensor 2026, an operation signal of a shift lever acquired by a shift lever sensor 2027, and a detection signal, acquired by an object detection sensor 2028, for detecting an obstacle, a vehicle, a pedestrian, and the like.

The information service unit 2012 includes various devices for providing (outputting) various kinds of information such as driving information, traffic information, and entertainment information, including a car navigation system, an audio system, a speaker, a television, and a radio, and one or more ECUs controlling these devices. The information service unit 2012 provides various types of multimedia information and multimedia services to the occupants of the vehicle 2001 by using information obtained from the external device through the communication module 2013 or the like. The information service unit 2012 may include an input device (for example, a keyboard, a mouse, a microphone, a switch, a button, a sensor, a touch panel, and the like) for receiving input from the outside, or may include an output device (for example, a display, a speaker, an LED lamp, a touch panel, and the like) for implementing output to the outside.

A driving support system unit 2030 includes: various devices for providing functions of preventing accidents and reducing driver's operating loads such as a millimeter wave radar, a LiDAR (Light Detection and Ranging), a camera, a positioning locator (e.g., GNSS, etc.), map information (e.g., high definition (HD) map, autonomous vehicle (AV) map, etc.), a gyro system (e.g., IMU (Inertial Measurement Unit), INS (Inertial Navigation System), etc.), an AI (Artificial Intelligence) chip, an AI processor; and one or more ECUs controlling these devices. In addition, the driving support system unit 2030 transmits and receives various types of information via the communication module 2013 to realize a driving support function or an autonomous driving function.

The communication module 2013 may communicate with the microprocessor 2031 and components of the vehicle 2001 via a communication port. For example, the communication module 2013 transmits and receives data via a communication port 2033, to and from a drive unit 2002, a steering unit 2003, an accelerator pedal 2004, a brake pedal 2005, a shift lever 2006, front wheels 2007, rear wheels 2008, an axle 2009, a microprocessor 2031 and a memory (ROM, RAM) 2032 in the electronic control unit 2010, and sensors 2021 to 2029 provided in the vehicle 2001.

The communication module 2013 is a communication device that can be controlled by the microprocessor 2031 of the electronic control unit 2010 and that is capable of communicating with external devices. For example, various kinds of information are transmitted to and received from external devices through radio communication. The communication module 2013 may be internal to or external to the electronic control unit 2010. The external devices may include, for example, a base station, a mobile station, or the like.

The communication module 2013 may transmit at least one of signals from the various sensors 2021 to 2028 described above input to the electronic control unit 2010, information obtained based on the signals, and information based on an input from the outside (a user) obtained via the information service unit 2012, to the external apparatus via radio communication. The electronic control unit 2010, the various sensors 2021 to 2028, the information service unit 2012, and the like may be referred to as input units that receive input. For example, the PUSCH transmitted by the communication module 2013 may include information based on the input.

The communication module 2013 receives various types of information (traffic information, signal information, inter-vehicle information, etc.) transmitted from the external devices and displays the received information on the information service unit 2012 provided in the vehicle 2001. The information service unit 2012 may be referred to as an output unit that outputs information (for example, outputs information to devices, such as a display, a speaker, or the like, based on the PDSCH received by the communication module 2013 (or data/information decoded from the PDSCH)). In addition, the communication module 2013 stores the various types of information received from the external devices in the memory 2032 available to the microprocessor 2031. Based on the information stored in the memory 2032, the microprocessor 2031 may control the drive unit 2002, the steering unit 2003, the accelerator pedal 2004, the brake pedal 2005, the shift lever 2006, the front wheel 2007, the rear wheel 2008, the axle 2009, the sensors 2021-2029, etc., mounted in the vehicle 2001.

### <Clause>

(Clause 1) A communication device including:
   a control unit configured to generate a codeword obtained by encoding information bits by using enhanced Polar codes to which XOR (Exclusive OR) operation addition and stopping of polarization by XOR operation deletion are applied; and
   a transmission unit configured to transmit the codeword to another communication device.
(Clause 2) The communication device as described in clause 1, wherein
   the stopping of polarization by XOR operation deletion is determined based on at least one of:
   communication channel capacity of a good communication channel;
   an error rate of the good communication channel in Polar codes;
   communication channel capacity of a poor communication channel; or
   an error rate of the poor communication channel in Polar codes.
(Clause 3) The communication device as described in clause 1, wherein
   the transmission unit transmits, to another communication device, configuration information including any one of:
   information related to a codeword length;
   information related to XOR operation addition position;
   information related to XOR operation deletion position;
   information related to a threshold value for determining XOR operation deletion; or
   information indicating an information bit position in the codeword.
(Clause 4) The communication device as described in clause 1, wherein
   in a case where configuration information related to the enhanced Polar codes is set or in a case where the configuration information is indicated,
   the control unit expects that a period that is shorter than that for a case where the enhanced Polar codes are not used is to be used with respect to at least one of:
      a decoding period of a downlink control channel;
      a decoding period of downlink control information;
      a decoding period of a downlink data channel;
      a preparation period of an uplink data channel;
      a preparation period of feedback information;
      a decoding period of an uplink control channel; or
      a decoding period of an uplink data channel.
(Clause 5) The communication device as described in clause 1, wherein
   the control unit configures different configuration information related to the enhanced Polar codes in accordance with at least one of:
   a type of coding information,
   a priority of the coding information, or
   a communication channel state.
(Clause 6) A communication method performed by a communication device, the communication method including:
   generating a codeword obtained by encoding information bits by using enhanced Polar codes to which XOR (Exclusive OR) operation addition and stopping of polarization by XOR operation deletion are applied; and
   transmitting the codeword to another communication device.

According to any one of clause 1 to clause 6, event subscription and indication can be performed in the IMS data channel network.

### (Supplement of embodiment)

As described above, one or more embodiments have been described. The present invention is not limited to the above embodiments. A person skilled in the art should understand that there are various modifications, variations, alternatives, replacements, etc., of the embodiments. In order to facilitate understanding of the present invention, specific values have been used in the description. However, unless otherwise specified, those values are merely examples and other appropriate values may be used. The division of the described items may not be essential to the present invention. The things that have been described in two or more items may be used in a combination if necessary, and the thing that has been described in one item may be appropriately applied to another item (as long as there is no contradiction). Boundaries of functional units or processing units in the functional block diagrams do not necessarily correspond to the boundaries of physical parts. Operations of multiple functional units may be physically performed by a single part, or an operation of a single functional unit may be physically performed by multiple parts. The order of sequences and flowcharts described related to an embodiment of the present invention may be changed as long as there is no contradiction. For the sake of description convenience, the base station 10 and the terminal 20 have been described by using functional block diagrams. However, the apparatuses may be realized by hardware, software, or a combination of hardware and software. The software executed by a processor included in the base station 10 according to an embodiment of the present invention and the software executed by a processor included in the terminal 20 according to an embodiment of the present invention may each be stored in a random access memory (RAM), a flash memory, a read only memory (ROM), an EPROM, an EEPROM, a register, a hard disk (HDD), a removable disk, a CD-ROM, a database, a server, or any other appropriate recording medium.

In addition, notification of information is by no means limited to the aspects/embodiments described in the present disclosure, and other methods may be used as well. For example, notification of information may be implemented by using physical layer signaling (for example, downlink control information (DCI), uplink control information (UCI)), higher layer signaling (for example, radio resource control (RRC) signaling, medium access control (MAC) signaling), broadcast information (master information block (MIB), system information block (SIB)), and other signals or combinations thereof. Also, RRC signaling may be referred to as an "RRC message," and can be, for example, an RRC connection setup message, an RRC connection reconfiguration message, and so on.

The aspects/embodiments illustrated in the present disclosure may be applied to Long Term Evolution (LTE), LTE-Advanced (LTE-A), LTE-Beyond (LTE-B), SUPER 3G, IMT-Advanced, 4th generation mobile communication system (4G), 5th generation mobile communication system (5G), 6th generation mobile communication system (6G), xth generation mobile communication system (xG (where x is, for example, an integer or a decimal)), Future Radio Access (FRA), New-Radio Access Technology (RAT), New Radio (NR), New radio access (NX), Future generation radio access (FX), W-CDMA (registered trademark), GSM (registered trademark), CDMA 2000, Ultra Mobile Broadband (UMB), IEEE 802.11 (Wi-Fi (registered trademark)), IEEE 802.16 (WiMAX (registered trademark)), IEEE 802.20, Ultra-WideBand (UWB), Bluetooth (registered trademark), systems that use other adequate radio communication methods, next-generation systems that are enhanced, modified, created, or defined based on these, and the like. In addition, a plurality of systems may be combined (for example, a combination of: at least one of LTE or LTE-A; 5G, and the like) to be applied. In addition, a plurality of systems may be combined (for example, a combination of: at least one of LTE or LTE-A; and 5G, and the like) to be applied.

The order of processes, sequences, flowcharts, and so on that have been used to describe the aspects/embodiments in the present specification may be re-ordered as long as inconsistencies do not arise. For example, although various methods have been illustrated in the present disclosure with various components of steps in exemplary orders, the specific orders that are illustrated herein are by no means limiting.

Operations which have been described in the present specification to be performed by a base station 10 may, in some cases, be performed by an upper node of the base station 10. In a network including one or a plurality of network nodes with base stations 10, it is clear that various operations that are performed to communicate with terminals 20 can be performed by base stations 10, one or more network nodes (for example, Mobility Management Entities (MMEs), Serving-Gateways (S-GWs), and so on may be possible, but these are not limiting) other than base stations 10, or combinations of these. According to the above, a case is described in which there is a single network node other than the base station 10. However, a combination of multiple other network nodes may be considered (e.g., MME and S-GW).

The information or signals described in this disclosure may be output from a higher layer (or lower layer) to a lower layer (or higher layer). The information or signals may be input or output through multiple network nodes.

The input or output information may be stored in a specific location (e.g., memory) or managed using management tables. The input or output information may be overwritten, updated, or added. The information that has been output may be deleted. The information that has been input may be transmitted to another apparatus.

A decision or a determination in the present disclosure may be implemented by a value (0 or 1) represented by one bit, by a Boolean value (true or false), or by comparison of numerical values (e.g., comparison with a predetermined value).

Software should be broadly interpreted to mean, whether referred to as software, firmware, middle-ware, microcode, hardware description language, or any other name, instructions, instruction sets, codes, code segments, program codes, programs, subprograms, software modules, applications, software applications, software packages, routines, subroutines, objects, executable files, executable threads, procedures, functions, and the like.

Further, software, instructions, information, and the like may be transmitted and received via a transmission medium. For example, in the case where software is transmitted from a website, server, or other remote source using at least one of wired line technologies (such as coaxial cable, fiber optic cable, twisted pair, digital subscriber line (DSL), etc.) or wireless technologies (infrared, microwave, etc.), at least one of these wired line technologies or wireless technologies is included within the definition of the transmission medium. For example, in the case where software is transmitted from a website, server, or other remote source using at least one of wired line technologies (such as coaxial cable, fiber optic cable, twisted pair, digital subscriber line (DSL), etc.) or wireless technologies (infrared, microwave, etc.), at least one of these wired line technologies or wireless technologies is included within the definition of the transmission medium.

Information, a signal, or the like, described in the present specification may be represented by using any one of various different technologies. For example, data, an instruction, a command, information, a signal, a bit, a symbol, a chip, or the like, described throughout the present application, may be represented by a voltage, an electric current, electromagnetic waves, magnetic fields, a magnetic particle, optical fields, a photon, or a combination thereof.

It should be noted that a term used in the present specification and/or a term required for understanding of the present specification may be replaced by a term having the same or similar meaning. For example, a channel and/or a symbol may be a signal (signaling). Further, a signal may be a message. Further, the component carrier (CC) may be referred to as a carrier frequency, cell, frequency carrier, or the like.

As used in the present disclosure, the terms "system" and "network" are used interchangeably.

Further, the information, parameters, and the like, described in the present disclosure may be expressed using absolute values, relative values from predetermined values, or they may be expressed using corresponding different information. For example, a radio resource may be what is indicated by an index.

The names used for the parameters described above are not used as limitations. Further, the mathematical equations using these parameters may differ from those explicitly disclosed in the present disclosure. Because various channels (e.g., PUCCH, PDCCH, or the like) and information elements may be identified by any suitable names, the various names assigned to these various channels and information elements are not used as limitations.

In the present disclosure, the terms "Base Station (BS)", "Radio Base Station", "Base Station Apparatus", "Fixed Station", "NodeB", "eNodeB (eNB)", "gNodeB (gNB)", "Access Point", "Transmission Point", "Reception Point", "Transmission/Reception Point", "Cell", "Sector", "Cell Group", "Carrier", "Component Carrier", and the like, may be used interchangeably. The base station may be referred to as the terms such as a "macro cell," a "small cell," a "femto cell," a "pico cell," and so on.

A base station can accommodate one or a plurality of (for example, three) cells. When a base station supports a plurality of cells, the entire coverage area of the base station can be partitioned into multiple smaller areas, and each smaller area can provide communication services through base station subsystems (for example, indoor small base stations (Remote Radio Heads (RRHs))). The term "cell" or "sector" refers to part of or the entire coverage area of at least one of a base station or a base station subsystem that provides communication services within this coverage.

In the present disclosure, transmitting information to the terminal by the base station may be referred to as instructing the terminal to perform any control and/or operation based on the information by the base station.

In the present disclosure, terms such as "mobile station (MS)", "user terminal", "user equipment (UE)", "terminal", and the like, may be used interchangeably.

A mobile station may be referred to as a "subscriber station," "mobile unit," "subscriber unit," "wireless unit," "remote unit," "mobile device," "wireless device," "wireless communication device," "remote device," "mobile subscriber station," "access terminal," "mobile terminal," "wireless terminal," "remote terminal," "handset," "user agent," "mobile client," "client," or some other appropriate terms in some cases.

At least one of a base station or a mobile station may be referred to as a "transmitting apparatus," a "receiving apparatus," a "radio communication apparatus," and so on. Note that at least one of a base station or a mobile station may be a device mounted on a moving object or a moving object itself, and so on. The mobile station is an object that can move, and the moving speed can be any speed. In addition, a mobile station that is not moving is also included. Examples of the moving object include a vehicle, a transport vehicle, an automobile, a motorcycle, a bicycle, a connected car, a loading shovel, a bulldozer, a wheel loader, a dump truck, a fork lift, a train, a bus, a trolley, a rickshaw, a ship and other watercraft, an airplane, a rocket, a satellite, a drone, a multicopter, a quadcopter, a balloon, and an object mounted on any of these, but these are not restrictive. The moving object may be a moving object that autonomously travels based on a direction for moving. The moving object may be a vehicle (for example, a car, an airplane, and the like), may be a moving object which moves unmanned (for example, a drone, an automatic operation car, and the like), or may be a robot (a manned type or unmanned type). Note that at least one of a base station or a mobile station also includes an apparatus which does not necessarily move during communication operation. For example, at least one of the base station or the mobile station may be an IoT (Internet of Things) device such as a sensor.

Furthermore, the base station in the present disclosure may be interpreted as a user terminal. For example, each aspect/embodiment of the present disclosure may be applied to the structure in which communications between a base station and a user terminal is replaced with communications between a plurality of terminals 20 (for example, which may be referred to as Device-to-Device (D2D), Vehicle-to-Everything (V2X), and the like). In this case, terminals 20 may have the functions of the base stations 10 described above. The words such as "uplink" and "downlink" may be interpreted as the words corresponding to the terminal-to-terminal communication (for example, "sidelink"). For example, an uplink channel, a downlink channel and so on may be interpreted as a sidelink channel.

Likewise, the user terminal in the present disclosure may be interpreted as base station. In this case, the base station may have the functions of the user terminal described above.

As used herein, the term "determining" may encompass a wide variety of actions. For example, "determining" may be regarded as judging, calculating, computing, processing, deriving, investigating, looking up (search, inquiry) (e.g., looking up in a table, a database or another data structure), ascertaining and the like. Also, "determining" may be regarded as receiving (e.g., receiving information), transmitting (e.g., transmitting information), inputting, outputting, accessing (e.g., accessing data in a memory) and the like. Also, "determining" may be regarded as resolving, selecting, choosing, establishing, comparing, and the like. That is, "determining" may be regarded as a certain type of action related to determining. Further, "decision" may be read as "assuming", "expecting", or "considering", etc.

The term "connected" or "coupled" or any variation thereof means any direct or indirect connection or connection between two or more elements and may include the presence of one or more intermediate elements between the two elements "connected" or "coupled" with each other. The coupling or connection between the elements may be physical, logical, or a combination thereof. For example, "connection" may be read as "access". As used in the present disclosure, the two elements may be thought of as being "connected" or "coupled" to each other using at least one of the one or more wires, cables, or printed electrical connections and, as a number of non-limiting and non-inclusive examples, electromagnetic energy having wavelengths in the radio frequency region, the microwave region, and the light (both visible and invisible) region.

A reference signal may be abbreviated as an "RS," and may be referred to as a "pilot," and so on, depending on which standard applies.

The phrase "based on" (or "on the basis of") as used in the present disclosure does not mean "based only on" (or "only on the basis of"), unless otherwise specified. In other words, the phrase "based on" (or "on the basis of") means both "based only on" and "based at least on" ("only on the basis of" and "at least on the basis of").

Reference to elements with designations such as "first," "second," and so on as used in the present disclosure does not generally limit the quantity or order of these elements. These designations may be used in the present disclosure only for convenience, as a method for distinguishing between two or more elements. Thus, reference to the first and second elements does not imply that only two elements may be employed, or that the first element must precede the second element in some way.

"Means" included in the configuration of each of the above apparatuses may be replaced by "parts", "circuits", "devices", etc.

In the case where the terms "include", "including" and variations thereof are used in the present disclosure, these terms are intended to be comprehensive in the same way as the term "comprising". Further, the term "or" used in the present specification is not intended to be an "exclusive or".

In the present disclosure, where an article is added by translation, for example "a", "an", and "the", the disclosure may include that the noun following these articles is plural.

In this disclosure, the term "A and B are different" may mean "A and B are different from each other." It should be noted that the term "A and B are different" may mean "A and B are different from C." Terms such as "separated" or "combined" may be interpreted in the same way as the above-described "different".

An aspect/embodiment described in the present specification may be used independently, may be used in combination, or may be used by switching according to operations. Further, notification (transmission/reporting) of predetermined information (e.g., notification (transmission/reporting) of "X") is not limited to an explicit notification (transmission/reporting), and may be performed by an implicit notification (transmission/reporting) (e.g., by not performing notification (transmission/reporting) of the predetermined information).

As described above, the present invention has been described in detail. It is apparent to a person skilled in the art that the present invention is not limited to one or more embodiments of the present invention described in the present specification. Modifications, alternatives, replacements, etc., of the present invention may be possible without departing from the subject matter and the scope of the present invention defined by the descriptions of claims. Therefore, the descriptions of the present specification are for illustrative purposes only, and are not intended to be limitations to the present invention.

### DESCRIPTION OF THE REFERENCE NUMERALS

10 Base station
110 Transmission unit
120 Reception unit
130 Configuration unit
140 Control unit
20 Terminal
210 Transmission unit
220 Reception unit
230 Configuration unit
240 Control unit
30 Network node
1001 Processor
1002 Memory
1003 Storage
1004 Communication apparatus
1005 Input apparatus
1006 Output apparatus
2001 Vehicle
2002 Drive unit
2003 Steering unit
2004 Accelerator pedal
2005 Brake pedal
2006 Shift lever
2007 Front wheel
2008 Rear wheel
2009 Axle
2010 Electronic control unit
2012 Information service unit
2013 Communication module
2021 Current sensor
2022 Revolution sensor
2023 Pneumatic sensor
2024 Vehicle speed sensor
2025 Acceleration sensor
2026 Brake pedal sensor
2027 Shift lever sensor
2028 Object detection sensor
2029 Accelerator pedal sensor
2030 Driving support system unit
2031 Microprocessor
2032 Memory (ROM, RAM)
2033 Communication port (IO port)

## Claims

1. A communication device comprising:
a control unit configured to generate a codeword obtained by encoding information bits by using enhanced Polar codes to which XOR (Exclusive OR) operation addition and stopping of polarization by XOR operation deletion are applied; and
a transmission unit configured to transmit the codeword to another communication device.

2. The communication device as claimed in claim 1, wherein
the stopping of polarization by XOR operation deletion is determined based on at least one of:
communication channel capacity of a good communication channel;
an error rate of the good communication channel in Polar codes;
communication channel capacity of a poor communication channel; or
an error rate of the poor communication channel in Polar codes.

3. The communication device as claimed in claim 1, wherein
the transmission unit transmits, to another communication device, configuration information including any one of:
information related to a codeword length;
information related to XOR operation addition position;
information related to XOR operation deletion position;
information related to a threshold value for determining XOR operation deletion; or
information indicating an information bit position in the codeword.

4. The communication device as claimed in claim 1, wherein
in a case where configuration information related to the enhanced Polar codes is set or in a case where the configuration information is indicated,
the control unit expects that a period that is shorter than that for a case where the enhanced Polar codes are not used is to be used with respect to at least one of:
a decoding period of a downlink control channel;
a decoding period of downlink control information;
a decoding period of a downlink data channel;
a preparation period of an uplink data channel;
a preparation period of feedback information;
a decoding period of an uplink control channel; or
a decoding period of an uplink data channel.

5. The communication device as claimed in claim 1, wherein
the control unit configures different configuration information related to the enhanced Polar codes in accordance with at least one of:
a type of coding information,
a priority of the coding information, or
a communication channel state.

6. A communication method performed by a communication device, the communication method comprising:
generating a codeword obtained by encoding information bits by using enhanced Polar codes to which XOR (Exclusive OR) operation addition and stopping of polarization by XOR operation deletion are applied; and
transmitting the codeword to another communication device.
